Europäisches Patentamt

**European Patent Office**

**Office européen des brevets**

(19)

(11) Veröffentlichungsnummer: **0 011 164**
**B1**

(12) **EUROPÄISCHE PATENTSCHRIFT**

(45) Veröffentlichungstag der Patentschrift:
02.03.83

(51) Int. Cl.³: **H 03 K 23/00,** H 03 K 21/36,
H 04 J 1/06

(21) Anmeldenummer: 79104145.2

(22) Anmeldetag: 25.10.79

(54) **Digitale Frequenzteileranordnung.**

(30) Priorität: 16.11.78 DE 2849797

(43) Veröffentlichungstag der Anmeldung:
28.05.80 Patentblatt 80/‾

(45) Bekanntmachung des Hinweises auf die Patenterteilung:
02.03.83 Patentblatt 83/9

(84) Benannte Vertragsstaaten:
AT BE CH FR IT LU NL SE

(56) Entgegenhaltungen:
**DE-A-2 523 131**
**DE-B-2 753 398**
**DE-B-2 753 453**
**GB-A-1 450 071**
**GB-A-2 005 882**
**US-A-3 906 374**
**US-A-3 967 205**
**TELCOM REPORT, Band 1, Nr. 5, Oktober 1978,**
**München, F. SONNTAG, »Dezentrale Trägerfre-**
**quenzversorgung für Systeme mit 300 bis 960**
**Fernsprechkanälen«, Seiten 335 bis 338**
**FREQUENZ, Band 30, Nr. 3, 1976, R. SCHRÖDER,**
**»Zur quasiperiodischen Frequenzteilung«, Seiten**
**50 bis 55**

(73) Patentinhaber: **SIEMENS AKTIENGESELLSCHAFT,**
**Berlin und München Wittelsbacherplatz 2,**
**D-8000 München 2 (DE)**

(72) Erfinder: **Sonntag, Fritz, Dipl.-Ing.,**
**Schwetzingen-Strasse 12, D-8000 München 60 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Digitale Frequenzteileranordnung

Die Erfindung bezieht sich auf eine digitale Frequenzteileranordnung für ein Teilungsverhältnis $\frac{Z}{N} < 1$, bei der die Spannung mit der zu teilenden Frequenz dem Eingang einer Logik zugeführt wird, bei der der Ausgang der Logik mit einem ersten Eingang eines ersten Frequenzteilers (2) mit einem ganzzahligen Teilungsfaktor n verbunden ist ($n > 1$), bei der der Ausgang des ersten Frequenzteilers (2) mit dem Eingang eines zweiten Frequenzteilers (3) mit einem Teilungsfaktor m verbunden ist ($m > 1$) und bei der der Ausgang des zweiten Frequenzteilers (3) mit einem zweiten Eingang der Logik verbunden ist.

Eine derartige Anordnung ist aus der Zeitschrift »Frequenz«, Band 30 (1976), Nr. 3, Seiten 50 bis 55, bekannt. Der dort beschriebene Frequenzteiler vermag zwar die gewünschte Frequenz abzugeben, jedoch nicht mit der maximal möglichen Energie. Dies beruht darauf, daß die Abweichung zur idealen Ausgangsimpulsfolge mit dem Impulspausenverhältnis 1 : 1 mit einem Fehler behaftet ist, der einer Eingangsperiode entspricht. Dies hat zur Folge, daß die Seitenbänder nur unzureichend gedämpft werden.

In der Trägerversorgung sind öfters Frequenzen abzuleiten, die kein Vielfaches einer Steuerfrequenz sind. Solche Frequenzen wie z. B. Pilote und Wahlruffrequenzen werden aus anderen schon vorhandenen Frequenzen (Trägern) mittels Teilung, Vervielfachung und Mischung abgeleitet. Oft tritt dabei Teilung und Vervielfachung gleichzeitig auf, z. B. $f_0 = \frac{Z}{N}(Z < N)$.

Die Realisierung des Bruches $\frac{Z}{N}$ soll digital durchgeführt werden, wobei der Energieanteil der Z-ten Harmonischen von $\frac{1}{N}$ den maximal möglichen Energieanteil haben soll und die daneben liegenden Harmonischen möglichst wenig Energie enthalten sollen.

Ein Verfahren und eine Schaltungsanordnung für eine derartige Frequenzteilung wurden bereits in den Patentanmeldungen DE-A1-2 753 398 und DE-A1-2 753 453 vorgeschlagen. Dort werden Impulsfolgen mittels Teiler-Logikschaltungen durch Abzählen der verschiedenen Puls- und Pausenbreiten erhalten. Für große Zahlen im Zähler und Nenner ist dieses Verfahren jedoch schwierig und mit einem relativ großen Schaltungsaufwand verbunden.

Die Aufgabe der vorliegenden Erfindung besteht darin, die eingangs geschilderte Anordnung derart zu verbessern, daß bei gleicher Eingangsfrequenz die Energie der Ausgangsimpulse vergrößert und die Seitenbänder entsprechend besser gedämpft sind.

Zur Lösung dieser Aufgabe wird gemäß der Erfindung die digitale Frequenzteileranordnung der einleitend geschilderten Art derart ausgebildet, daß als Logik ein Exklusiv-ODER-Gatter vorgesehen ist, daß ein dritter Frequenzteiler mit einem ganzzahligen Teilungsfaktor k vorgesehen ist, dessen Eingang mit dem Ausgang des ersten Frequenzteilers verbunden ist und dessen Ausgang als Gesamtausgang dient, daß alle Frequenzteiler bei Ansteuerung mit einer symmetrischen Rechteckspannung am Ausgang stets eine Rechteckspannung mit dem Impulspausenverhältnis 1 : 1 abgeben und daß der Teilungsfaktor m dadurch bestimmt wird, daß der Zähler Z des rationalen Teilungsverhältnisses durch die Differenz aus dem Produkt von Zähler Z und Teilungsfaktor n und dem Quotienten aus dem Nenner N und dem Teilungsfaktor k geteilt wird.

Zwar ist aus der US-PS 3 906 374 bereits eine Anordnung mit Exklusiv-ODER-Gatter und Zähler bekannt, die einen symmetrischen ganzzahligen Teiler darstellt, jedoch würde beim Einsetzen einer derartigen Anordnung in den Frequenzteiler nach Bild 1 der zitierten Zeitschrift »Frequenz« nur ein Teiler, nicht aber die Logik ersetzt.

Durch die erfindungsgemäßen Maßnahmen erhält man eine digitale Frequenzteileranordnung für Teilungsverhältnisse kleiner 1 mit geringem Bauteileaufwand. Die Schaltung kann auch für komplizierte Teilungsverhältnisse rasch ermittelt werden.

In weiterer Ausgestaltung der Erfindung läßt sich der digitale Frequenzteiler auch derart aufbauen, daß bei einem nicht ganzzahligen Teilungsfaktor m des zweiten Frequenzteilers dieser mit einem Exklusiv-ODER-Gatter und mit zwei weiteren Frequenzteilern, die wie nach Anspruch 1 zusammengeschaltet sind, realisiert ist und die Teilungsfaktoren n', m', k' dieser weiteren Frequenzteiler wie nach Anspruch 1 dimensioniert sind, wobei vom Kehrwert des nicht ganzzahligen Teilungsfaktors m des zweiten Frequenzteilers als rationalem Teilungsfaktor ausgegangen wird.

Der jeweilige zweite Frequenzteiler mit dem Teilungsfaktor m, m' ... muß sooft durch eine Frequenzteileranordnung nach Anspruch 1 realisiert werden, bis der jeweilige Teilungsfaktor m nach der Dimensionierung nach Anspruch 2 ganzzahlig ist.

Bei Verwendung von programmierbaren Teilern läßt sich die Teilerschaltung für andere Teilungsverhältnisse leicht umprogrammieren.

Anhand der Ausführungsbeispiele nach den F i g. 1 bis 3 wird die Erfindung näher erläutert.

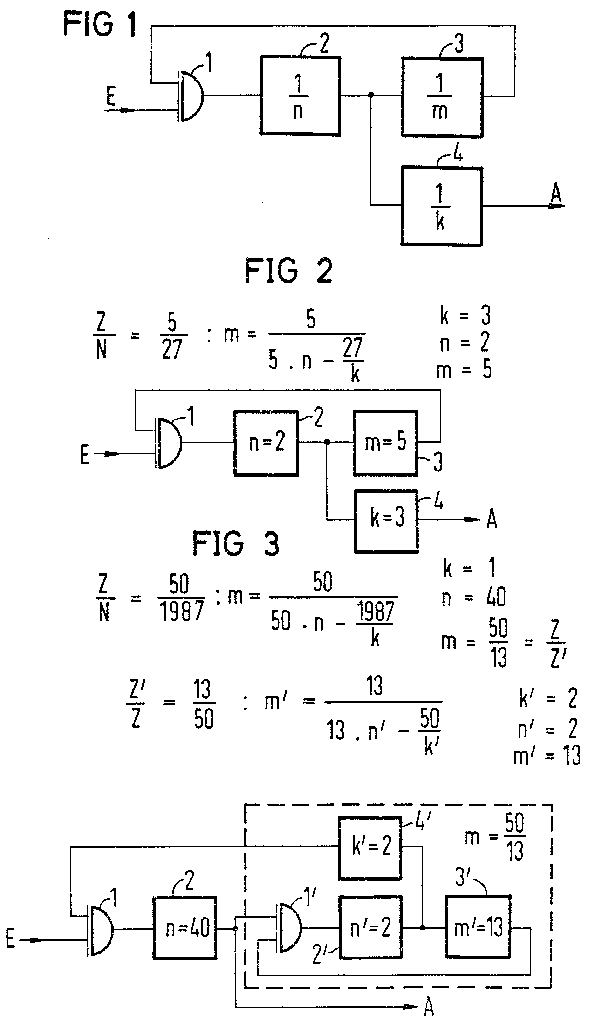

Fig. 1 zeigt dabei eine Teilergrundschaltung. Diese besteht aus den drei Teilerschaltungen 2, 3 und 4 mit Teilungsverhältnissen, $\frac{1}{n}, \frac{1}{m}, \frac{1}{k}$, sowie aus einem Exklusiv-ODER-Gatter 1. Der Ausgang des Exklusiv-ODER-Gatters 1 ist mit dem Eingang des Teilers 2 und dessen Ausgang wiederum mit den Eingängen der Teiler 3 und 4 verbunden. Der Ausgang des Teilers 3 ist mit dem einen Eingang des Exklusiv-ODER-Gatters 1 verbunden, dem zweiten Eingang E wird die zu teilende symmetrische Taktfrequenz zugeführt. Der Ausgang A des Teilers 4 bildet auch den eigentlichen Ausgang der Teilergrundschaltung.

Am Ausgang der Frequenzteileranordnung erhält man eine Impulsfolge, in der die gewünschte Z. Harmonische von $\frac{1}{N}$ immer den, mittels der Fourieranalyse errechenbaren, maximalen Energieanteil enthält und die nicht gewünschten Harmonischen entsprechend gedämpft sind.

Die Bestimmung der einzelnen Teilungsfaktoren in der Teilergrundschaltung erfolgt nach der Formel:

$$m = \frac{Z}{Z \cdot n - \dfrac{N}{k}}$$

Z = Zähler des zu realisierenden Bruches

N = Nenner des zu realisierenden Bruches

n, m, k = Teilungsfaktoren der Teiler in der Teilergrundschaltung

Fig. 2 zeigt ein praktisches Ausführungsbeispiel für ein Teilungsverhältnis $\frac{Z}{N} = \frac{5}{27}$, wobei für k = 3 und für n = 2 gewählt ist. Für m ergibt sich dann der Teilungsfaktor 5.

Ein Ausführungsbeispiel, bei dem für m ein nicht ganzzahliger Teilungsfaktor entsteht, ist in Fig. 3 gezeigt. Dabei wird der zweite Frequenzteiler 3 durch einen weiteren Frequenzteiler ersetzt, der wiederum so aufgebaut ist, wie der Frequenzteiler nach Fig. 1. Für n ergibt sich dabei 40, für k = 1, so daß dieser Frequenzteiler der Einfachheit halber nicht dargestellt ist. Für m ergibt sich $\frac{50}{13}$. Als Ausgangswert für den neu zu berechnenden Teilungsfaktor wird nunmehr der reziproke Wert $\frac{13}{50}$ verwendet. Bei der Wahl der Teilungsfaktoren k' = 2 und n' = 2 erhält man schließlich für m' = 13.

Damit erhält man isgesamt folgende Teilungsfaktoren k = 1, n = 40, k' = 2, n' = 2, m' = 13, und man erhält am Ausgang dieses Frequenzteilers das gewünschte Teilungsverhältnis 50 : 1987.

Für den Fall, daß m' wiederum keinen ganzzahligen Teilungsfaktor ergibt, wird für m' wiederum eine Teilerschaltung nach Fig. 1 verwendet, so daß man eine fortlaufende Kaskadenschaltung erhält, wobei diese Kaskade solange fortgesetzt wird, bis sich für den Teilungsfaktor m in der letzten Kaskade ein ganzzahliger Teilungsfaktor ergibt.

## Patentansprüche

1. Digitale Frequenzteileranordnung für ein Teilungsverhältnis $\frac{Z}{N} < 1$, bei der die Spannung mit der zu teilenden Frequenz dem Eingang einer Logik zugeführt wird, bei der der Ausgang der Logik mit einem ersten Eingang eines ersten Frequenzteilers (2) mit einem ganzzahligen Teilungsfaktor n verbunden ist (n > 1), bei der der Ausgang des ersten Frequenzteilers (2) mit dem Eingang eines zweiten Frequenzteilers (3) mit einem Teilungsfaktor m verbunden ist (m > 1) und bei der der Ausgang des zweiten Frequenzteilers (3) mit einem zweiten Eingang der Logik verbunden ist, dadurch gekennzeichnet, daß als Logik ein Exklusiv-ODER-Gatter (1) vorgesehen ist, daß ein dritter Frequenzteiler (4) mit einem ganzzahligen Teilungsfaktor k vorgesehen ist, dessen Eingang mit dem Ausgang des ersten Frequenzteilers (2) verbunden ist und dessen Ausgang als Gesamtausgang dient, daß alle Frequenzteiler (2, 3, 4) bei Ansteuerung mit einer symmetrischen Rechteckspannung am Ausgang stets eine Rechteckspannung mit dem Impulspausenverhältnis 1 : 1 abgeben und daß der Teilungsfaktor m dadurch bestimmt wird, daß der Zähler Z des rationalen Teilungsverhältnisses durch die Differenz aus dem Produkt von Zähler Z und Teilungsfaktor n und dem Quotienten aus dem Nenner N und dem Teilungsfaktor k geteilt wird.

2. Digitale Frequenzteileranordnung nach Anspruch 1, dadurch gekennzeichnet, daß bei einem nicht ganzzahligen Teilungsfaktor m des zweiten Frequenzteilers (3) dieser mit einem Exklusiv-ODER-Gatter (1') und mit zwei weiteren Frequenzteilern (2', 3'), die wie nach Anspruch 1 zusammengeschaltet sind, realisiert ist und die Teilungsfaktoren n', m', k' dieser weiteren Frequenzteiler (2', 3') wie nach Anspruch 1 dimensioniert sind, wobei vom Kehrwert des nicht ganzzahligen Teilungsfaktors m des zweiten Frequenzteilers (3) als rationalem Teilungsfaktor ausgegangen wird.

3. Digitale Frequenzteileranordnung nach einem der vorhergehenden Ansprüche, dadurch gekennzeichnet, daß der jeweilige zweite Frequenzteiler mit dem Teilungsfaktor m, m' ... sooft durch eine Frequenzteileranordnung nach Anspruch 1 realisiert wird, bis der jeweilige Teilungsfaktor m nach der Dimensionierung nach Anspruch 2 ganzzahlig ist.

4. Digitale Frequenzteileranordnung nach einem der vorhergehenden Ansprüche, dadurch gekennzeichnet, daß die drei Einzelfrequenzteiler (2, 3, 4; 2', 3', 4' ...) aus programmierbaren Zählern bestehen.

## Claims

1. Digital frequency divider arrangement for a division ration $\frac{Z}{N} < 1$,

wherein the voltage together with the frequency to be divided is fed to the input of a logic unit,
wherein the output of the logic unit is connected to a first input of a first frequency divider (2) having an integral division factor n (n > 1),
wherein the output of the first frequency divider (2) is connected to the input of a second frequency divider (3) having a division factor m (m > 1), and
wherein the output of the second frequency divider (3) is connected to a second input of the logic unit,
characterised in that an exclusive-OR-gate (1) is provided as logic unit,
that there is provided a third frequency divider (4) having an integral division factor k, whose input is connected to the output of the first frequency divider (2) and whose output serves as a general output,
that when operated with a symmetrical rectangular voltage, all frequency dividers (2, 3, 4) always emit a rectangular voltage having the pulse-pause-ratio 1 : 1 at the output, and
that the division factor m is determined in that the numerator Z of the rational division ratio is divided by the difference of the product of numerator Z and division factor n and the quotient of the denominator N and the division factor k.

2. Digital frequency divider arrangement as claimed in claim 1, characterised in that in the case of a nonintegral division factor m of the second frequency divider (3), the latter is realised by means of an exclusive-OR-gate (1') and two further frequency dividers (2', 3'), which are interconnected as claimed in claim 1, and the division factors (n', m', k') of these further frequency dividers (2', 3') are dimensioned as claimed in claim 1, where the reciprocal value of the non-integral division factor m of the second frequency divider (3) is assumed as rational division factor.

3. Digital frequency divider arrangement as claimed in one of the preceding claims, characterised in that the respective second frequency divider having the division factor m, m' ... is realised by a frequency divider arrangement as claimed in claim 1 as many times until the respective division factor m is integral in accordance with the dimensioning as calimed in claim 2.

4. Digital frequency divider arrangement as claimed in one of the preceding claims, characterised in that the three individual frequency dividers (2, 3, 4; 2', 3', 4' ...) comprise programmable counters.

**Revendications**

1. Circuit diviseur de fréquence numérique pour un rapport de division $\frac{Z}{N} < 1$, dans lequel la tension est envoyée, avec la fréquence devant être divisée, à l'entrée d'un circuit logique, dans lequel la sortie du circuit logique est reliée à une première entrée d'un premier diviseur de fréquence (2) possédant un facteur de division entier n (n > 1), dans lequel la sortie du premier diviseur de fréquence (2) est reliée à l'entrée d'un second diviseur de fréquence (3) possédant un facteur de division m (m > 1) et dans lequel la sortie du second diviseur de fréquence (3) est reliée à une seconde entrée du circuit logique, caractérisé en ce qu'il est prévu, comme circuit logique, une porte OU-Exclusif (1), qu'il est prévu un troisième diviseur de fréquence (4) possédant un facteur de division entier k et dont l'entrée est reliée à la sortie du premier diviseur de fréquence (2) et dont la sortie sert de sortie globale, que tous les diviseurs de fréquence (2, 3, 4) délivrent, à la sortie, en permanence une tension rectangulaire possédant le rapport d'impulsions 1 : 1, lors d'une attaque avec une tension rectangulaire symétrique, et que le facteur de division m est déterminé par le fait que le numérateur Z du rapport de division rationnel est divisé par la différence entre le produit du numérateur Z et du facteur de division n et le quotient du dénominateur N et du facteur de division k.

2. Circuit diviseur de fréquence numérique selon la revendication 1, caractérisé en ce que, dans le cas d'un facteur de division m, non entier, du second diviseur de fréquence (3), ce dernier est réalisé par une porte OU-Exclusif (1') et par deux autres diviseurs de fréquence (2', 3') qui sont interconnectés comme indiqué dans la revendication 1, et que les facteurs de division n', m', k' de ces autres diviseurs de fréquence (2', 3') sont dimensionnés comme indiqué dans la revendication 1, en partant de l'inverse du facteur de division non entier m du second diviseur de fréquence (3), en tant que facteur de division rationnel.

3. Circuit diviseur de fréquence numérique selon l'une des revendications précédentes, caractérisé en ce que le second diviseur de fréquence concerné possédant le facteur de division m, m' ... est réalisé autant de fois par un circuit diviseur de fréquence selon la revendication 1, jusqu'à ce que le facteur de division concerné m soit un nombre entier, avec dimensionnement selon la revendication 2.

4. Circuit diviseur de fréquence numérique selon l'une des revendications précédentes, caractérisé en ce que les trois diviseurs de fréquence individuels (2, 3, 4; 2', 3', 4' ...) sont constitués par des compteurs programmables.

## FIG 1

## FIG 2

$$\frac{Z}{N} = \frac{5}{27} \quad : m = \frac{5}{5 \cdot n - \frac{27}{k}}$$

$k = 3$
$n = 2$
$m = 5$

## FIG 3

$$\frac{Z}{N} = \frac{50}{1987} : m = \frac{50}{50 \cdot n - \frac{1987}{k}}$$

$k = 1$
$n = 40$
$m = \frac{50}{13} = \frac{Z}{Z'}$

$$\frac{Z'}{Z} = \frac{13}{50} \quad : \quad m' = \frac{13}{13 \cdot n' - \frac{50}{k'}}$$

$k' = 2$
$n' = 2$
$m' = 13$

$$m = \frac{50}{13}$$